# EUROPEAN PATENT SPECIFICATION

(11) **EP 3 706 193 B1**
(45) Date of publication and mention of the grant of the patent: **14.06.2023**
(21) Application number: 20159756.4
(22) Date of filing: 27.02.2020
(51) Int. Cl.: B29C 70/08, B29C 70/48, B29C 70/84, B29C 70/88, H05K 9/00, H01M 50/222, H01M 50/224, H01M 50/227, H01M 50/229, H01M 50/231, H01M 50/24

(54) **PROTECTIVE CASE FOR BATTERIES AND METHOD FOR THE PRODUCTION OF A PROTECTIVE CASE FOR BATTERIES**
BATTERIESCHUTZGEHÄUSE UND HERSTELLUNGSVERFAHREN FÜR EIN BATTERIESCHUTZGEHÄUSE
ETUI DE PROTECTION POUR BATTERIES ET PROCEDE DE FABRICATION DE L'ETUI DE PROTECTION POUR BATTERIES

(30) Priority: 05.03.2019 IT 201900003191
(43) Date of publication of application: 09.09.2020
(73) Proprietor: Ranger Compositi S.r.l., 13851 Castelletto Cervo (BI) (IT)
(72) Inventor: Ali, Enrico Maria, 13851 Castelletto Cervo BI (IT)
(74) Representative: Perani & Partners S.p.A.

(56) References cited:
- WO-A1-2013/013906
- DE-U1-202012 104 339
- JP-A- 2012 109 452
- JP-A- 2016 219 466
- KR-A- 20180 053 084

## Description

### Technical field

The present invention relates to a protective case for batteries and a method for the production of a protective case for batteries.

### State of the Art

It is known from the state of the art to make protective cases for batteries which at the same time provide shock protection and a shield for electromagnetic radiation emitted by the battery itself. In particular, the battery cases have a shell made of plastic material reinforced with glass fibers to provide structural integrity. The shielding properties are instead typically provided by a metal grid inserted inside the shell or by a polymeric coating containing metals applied on the external surface of the shell.

Some examples of protective cases are described in documents DE 202012104339 U1, JP 201621966 A and JP 2012109452 A in which the shielding layer is made of metal material or its fibers.

Further examples of protective cases are described in the documents KR 20180053084 A and WO 2013013906 A1 in which the shielding layer has a dispersion of metal material.

In particular, the document KR 20180053084 A relates to a shielding structure made by means of a compression molding technique, in which the shielding layer comprises reinforcement fibers and metal material disposed in its inside. In detail, the shielding structure is made by stacking the layers, previously impregnated with resin, one on top of the other. Subsequently, the overlapping layers are subjected to compression in a mold to obtain the desired shape.

As regards document WO 2013013906 A1, the protective case is made by means of a production method which envisages impregnating the individual layers in a resin matrix and the subsequent stabilization in an autoclave. In particular, the layers are individually impregnated and stacked one on top of the other. Subsequently, the layers are stabilized by the combination of a heating and compression step in order to facilitate the polymerization of the resin matrix.

### Problems of the prior art

The cases currently used to shield batteries do not guarantee an adequate structural integrity. In fact, the metal grid and/or the shielding layer inserted inside the shell during the production step causes an uneven distribution of the plastic material forming weakening areas of the shell. This entails not only a lower impact resistance of the shell but also an ineffective shielding against electromagnetic radiation in the event that the exposed metal grid, in the weakened areas, comes into contact with a conductive material.

Furthermore, it should be noted that the means currently used for shielding batteries do not guarantee effective shielding against electromagnetic radiation emitted by the batteries. In fact, the grid and/or the shielding layer during the production process may be subject to slippage within the mold forming areas of the shell in which a radiation shield is effectively absent. Furthermore, the polymeric coating with metal materials does not guarantee a uniform distribution of the shielding layer thus allowing the passage of radiation.

It should be noted that the known production processes to make the protective cases can lead to an uneven distribution of the resin matrix reducing the structural integrity of the case itself in addition to the incorrect positioning of the shielding layer. In fact, during compression, the resin with which the layers are impregnated can escape partially and/or totally thus reducing the cohesion between the layers. The excess resin can also cause its accumulation between the layers causing unwanted deformities.

Furthermore, the known methods which employ the combination of the impregnation of the layers with the compression step limit the types of possible shapes for the case in addition to the complications due to the machinery.

### Object of the Invention

The object of the invention is to provide a case for batteries capable of overcoming the above mentioned drawbacks of the prior art.

In particular, it is an object of the present invention to provide a case capable of ensuring effective shielding against electromagnetic radiation emitted by a battery.

A further object of the present invention is to provide a method for the production of a case for batteries which guarantees the production of cases for batteries which effectively shield electromagnetic radiation, reducing production costs.

The specified technical task and the specified purposes are substantially achieved by a protective case for batteries and by a method for the production of a protective case for batteries comprising the technical characteristics set forth in one or more of the appended claims.

### Advantages of the Invention

Advantageously, the protective case allows to uniformly shield the battery from electromagnetic radiation.

Advantageously, the protective case allows it to adapt to any shape of the mold during production.

Advantageously, the combination of the multilayer structure and the resin matrix provide structural integrity to the case and shielding properties

### BRIEF DESCRIPTION OF THE DRAWINGS

Further characteristics and advantages of the present invention will become clearer from the indicative and therefore non-limiting description of a preferred but not exclusive embodiment of a protective case for batteries and a method for the production of cases for batteries:

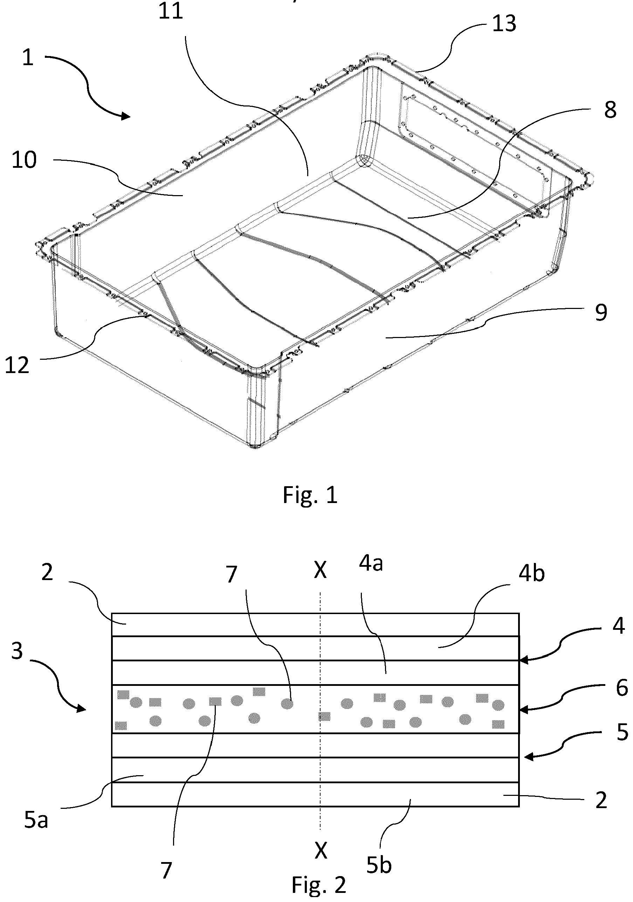

- Figure 1 shows a perspective view of the protective case for batteries according to an embodiment of the present invention;
   Figure 2 shows a section view of a portion of the protective case for batteries of Figure 1;

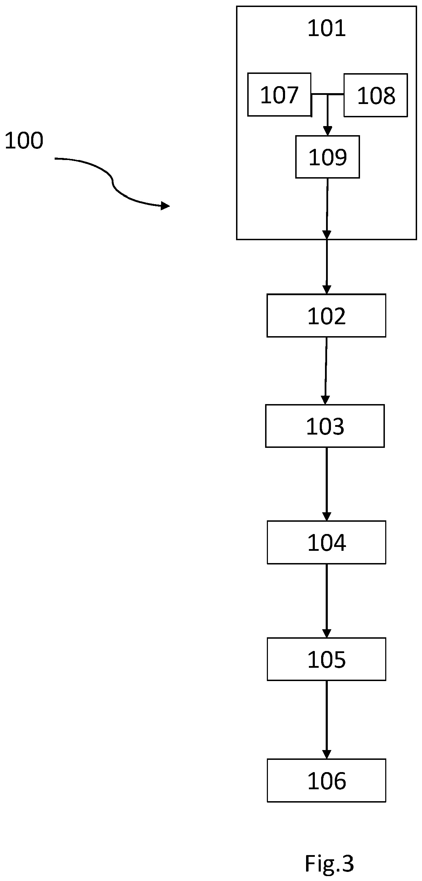

- Figure 3 shows a flow diagram of the steps of the method of the present invention.

### DETAILED DESCRIPTION

Even when not explicitly highlighted, the individual features described with reference to the specific embodiments must be considered as accessories and/or exchangeable with other features, described with reference to other embodiments.

With reference to the appended figures, 1 indicates a protective case for batteries according to the present invention.

This case for batteries 1 comprises a resin matrix 2 and a multilayer structure 3 embedded in the resin matrix 2 and configured to protect a battery. Preferably, the resin matrix 2 is of the epoxy type. Preferably, the multilayer structure 3 comprises a first 4 and a second reinforcement layer 5 configured to provide structural support to the case for batteries 1. More preferably, the multilayer structure 3 comprises a shielding layer 6 configured to shield electromagnetic radiation emitted by a battery and disposed between the first 4 and the second reinforcement layers 5.

In particular, the shielding layer 6 has a dispersion of metal material 7. Preferably, the shielding layer 6 has a surface and/or interstitial metallization.

Preferably, the metal material 7 is highly conductive metal for example nickel and/or copper.

More preferably, the shielding layer 6 comprises a polyester fabric on which the metal material 7 is dispersed. Alternatively, the shielding layer 6 can comprise a polyester non-woven fabric, known as TNT, on which the metal material 7 is dispersed.

In other words, the shielding layer 6 defines a Faraday cage by means of the metal materials dispersed on the fabric or on the non-woven fabric so as to isolate the battery from electromagnetic wave emissions.

In particular, the shielding layer 6, comprising the polyester fabric or non-woven fabric, has elastic properties, in order to ensure the correct positioning of the layer itself inside the multilayer structure 3 also during positioning in the mold. In fact, the use of a polyester fabric or non-woven fabric allows the adaptability of the shielding layer 6 to different mold shapes while maintaining effective shielding over the entire protective case 1. In fact, the fabric and the non-woven polyester fabric guarantee a uniform insulation from electromagnetic waves over the entire protective case for batteries 1.

Advantageously, the protective case for batteries 1 can be used to shield any electromagnetic radiation emitted by an electronic device. Preferably, the protective case for batteries 1 is used in the automotive field to prevent radiation emitted by a battery from affecting the electronics of a vehicle.

Advantageously, the dispersion of metal material 7 on the shielding layer provides a uniform shielding effect on the whole case for batteries 1.

Advantageously, the shielding layer 6, thanks to its adaptability, allows reproducing the mold shapes.

It should be noted that the layers 4, 5, 6 are disposed in succession along a longitudinal direction X-X. Preferably the layers 4, 5, 6 have a substantially twodimensional shape, for example sheet-like or planar perpendicular to the longitudinal direction X-X.

According to an embodiment, the first 4 and the second reinforcement layers 5 comprise reinforcement materials, preferably glass fibers and/or carbon fibers. According to an alternative embodiment with respect to the previous one, the first and second reinforcement layers 4, 5 comprise fabrics in which glass and/or carbon fibers are inserted.

Advantageously, the first and second reinforcement layers 4, 5 in combination with the resin matrix 2 provide structural integrity to the case for batteries 1 following the polymerization of the resin.

Advantageously, the protective case for batteries 1 provides the battery with protection from impacts or external agents.

Before being embedded in a resin matrix and its consolidation, the multilayer structure 3 is flexible and adaptable to a mold for resin molding known to the skilled technician in the sector.

Preferably, the multilayer structure 3 is made by co-extrusion or co-molding. In other words, the layers 4, 5, 6 are mutually coupled together before being embedded in the resin matrix thus remaining flexible and easily adaptable to the different mold shapes.

The shielding layer 6, being constrained to the reinforcement layers 4, 5, avoids slipping and due to the elasticity of the polyester fabric or non-woven fabric it easily follows the deformations of the reinforcement layers 4, 5 during the assembly of the multilayer structure 3. In particular, the co-extruded or co-molded multilayer structure 3 maintains flexibility, strength and even and uniform shielding.

Advantageously, the flexibility of the multilayer structure 3 simplifies the production of a case for batteries 1 capable of shielding electromagnetic radiation as it increases the adaptability of the multilayer structure to different shapes of mold. According to an embodiment, the first reinforcement layer 4 and the second reinforcement layer 5 each comprise a first and a second reinforcement sublayer 4a, 4b, 5a, 5b. In particular, each first reinforcement sublayer 4a, 5a is interposed between the shielding layer 6 and the respective second reinforcement sublayer 4b, 5b. In detail, the multilayer structure 3 overlaps, along the longitudinal direction X-X, the first and second reinforcement sublayer 4a, 4b of the first reinforcement layer 4, of the shielding layer 6 and of the first and second reinforcement sublayer 5a, 5b of the second reinforcement layer 5. In other words, each second sublayer 4b, 5b faces a resin mold for molding known to the technician skilled in the art. Vice versa, each first sublayer 4a, 5a and the shielding layer 6 are positioned between the second sublayers 4b, 5b.

Advantageously, the use of the first and second sublayers 4a, 4b, 5a, 5b allows to add a further layer of reinforcement fibers and/or flame-retardant materials to protect a battery.

The protective case for batteries 1 comprises a base 8 and a side wall 9 which extends from the base 8 to an opening 10. In particular, the base 8 and the side wall 9 define a cavity 11 inside which a battery can be placed. In detail, the side wall 9 has an edge 12 opposite the base 8 defining the opening 10. Preferably, the side wall 9 comprises a flange 13 which extends in a cantilever fashion from the edge 12 towards the outside of the cavity 11. Said flange 13 is configured to fix the protective case for a battery 1 to a support on which a battery is fixed.

The protective case for batteries 1 is made according to the method 100 object of the present invention.

The method for forming a protective case 100 comprises the steps of providing 101 the multilayer structure 3 and of providing 102 a mold for a battery case, not shown. In particular, the mold of a battery case typically used in the resin molding field provides for a male mold and a female mold.

The method comprises the step 103 of placing the multilayer structure 2 in the female mold. It should be noted that the flexibility of the multilayer structure 3, described above, favours the adaptability of the multilayer structure to the different shapes of the female mold and the relative male mold. After placing the multilayer structure inside the female mold, the method comprises the step 104 of closing the mold of a battery case by placing the male mold over the relative female mold and fixing them to each other by means of constraint means, not shown. In this way, the multilayer structure 3 is enclosed within the mold.

Advantageously, the multilayer structure 3, thanks to its flexibility, allows it to adapt to the different mold shapes.

The method for forming a protective case 100 includes the step 105 of injecting resin into the mold to form the protective case for batteries 1. In this way, the resin matrix 2 is uniformly distributed within the mold, incorporating the multilayer structure 3 and preferably forming an external surface layer on the multilayer structure 3.

Preferably, the step of injecting resin 105 is carried out by using the method of molding with high-pressure resin transfer (HP-RTM). Advantageously, the use of HP-RTM technology combined with the flexible multilayer structure 3 allows the series production of the protective battery cases while maintaining the shielding properties and high structural resistance. In fact, the HP-RTM methodology allows a uniform distribution of the resin inside the mold allowing to incorporate the entire multilayer structure 3.

The method for forming a protective case 100 includes the step 106 of removing the protective case 1 from the mold after curing of the injected resin. Preferably, after the insertion of the resin inside the mold, a predetermined time interval is waited for the complete polymerization of the resin 2 in which the multilayer structure 3 is embedded. In this way, the protective case for batteries 1 takes the shape defined by the mold, presenting the structural rigidity and shielding properties given by the combination of the resin matrix 2 and the multilayer structure 3.

It should be noted that the step of providing 101 a multilayer structure comprises a sub-step of forming 107 the first and second reinforcement layers 4, 5 preferably by arranging a plurality of reinforcement fibers according to a predefined or random weave. In other words, the sub-step 107 of forming the first and second reinforcement layers 4, 5 envisages providing a fabric and/or a non-woven fabric (TNT) having characteristics of impact resistance and/or flame resistance after curing of the matrix resin 2. However, before polymerization, a fabric and/or a non-woven fabric (TNT) of the first and second reinforcement layers 4, 5 are flexible and adaptable to the mold.

The step of providing 101 a multilayer structure comprises a sub-step 108 of forming the shielding layer 6 by placing metal material 7 on a polyester fabric or on a non-woven polyester fabric. Preferably, the metal material 7 is fixed on the fabric or on the non-woven fabric by means of a polyester matrix. In this way, the shielding layer 6 is flexible and adaptable to the different shapes of the mold as it is made of flexible fabric or non-woven fabric. Furthermore, the flexibility of the shielding layer 6 favours the coupling with the reinforcement layers 4, 5 which are also flexible.

In particular, the elastic and adaptability properties of the shielding layer 6 combined with the reinforcement layers 4 and 5 favour the mutual coupling of the same without mutual slippage.

Advantageously, the shielding layer 6 provides a shield for the electromagnetic radiation emitted by a battery due to the presence of metal material which is disposed on the surface or inside the fabric or non-woven fabric.

More preferably, the shielding layer is made according to a co-extrusion or co-molding process.

The step of providing 101 a multilayer structure comprises the sub-step 109 of assembling the multilayer structure 3 by placing the shielding layer 6 between the first 4 and the second reinforcement layers 5. Preferably, the layers 4, 5, 6 overlap each other along the longitudinal direction X-X and constrained together according to a co-extrusion or co-molding process. In particular, the layers 4, 5, 6 are rigidly coupled to each other by means of the co-extrusion or co-molding process ensuring the correct positioning of the shielding layer 6. In addition, a co-extruded or co-molded multilayer structure 3 maintains the flexibility, elasticity and adaptability properties of the layers 4, 5, 6. In other words, the co-extrusion or co-molding process allows constraining the layers 4, 5, 6 together, avoiding mutual slippage during positioning in the mold and/or in the subsequent steps of the process and maintaining the shielding and adaptability properties of the layers.

Advantageously, the production of the multilayer structure 3 through the co-extrusion or co-molding process guarantees greater uniformity in the distribution of the reinforcement material of the reinforcement layers and uniformity of the shielding of the shielding layer while maintaining the flexibility of the multilayer structure 3.

According to an alternative embodiment to the previous one, the fabric or non-woven fabric of the shielding layer are made of reinforcement material such as for example carbon fibers and/or carbon and/or kevlar fibers. Advantageously, the metallization of the fabrics or non-woven fabrics with the dispersion of metal materials reduces the production costs and allows the realization of the protective case for batteries having a single flexible and adaptable layer with both shielding and structural resistance properties.

## Claims

1. A protective case for batteries (1) of vehicles comprising:
- a resin matrix (2),
- a multilayer structure (3) embedded in the resin matrix (2) and configured to protect a battery, the multilayer structure (3) comprising at least one first reinforcement layer (4) and one second reinforcement layer (5),
- a shielding layer (6) configured to shield the electromagnetic radiation emitted by the battery and disposed between the first (4) and second (5) reinforcement layers, the shielding layer (6) having a dispersion of metal material (7)
**characterized in that** the shielding layer (6) comprises:
- a polyester fabric with metal material (7) dispersed thereon, or
- a polyester non-woven fabric with metal material (7) dispersed thereon.

2. Protective case for batteries (1) as claimed in claim 1, wherein the multilayer structure (3) is co-extruded or co-molded.

3. Protective case for batteries (1) as claimed in claims 1 or 2, wherein the first reinforcement layer (4) and the second reinforcement layer (5) comprise reinforcement material fibers.

4. Protective case for batteries (1) as claimed in claim 3, wherein the reinforcement material fibers are glass fibers and/or carbon fibers.

5. Protective case for batteries (1) as claimed in any of claims 1 to 4, wherein each of the first reinforcement layer (4) and the second reinforcement layer (5) comprises first and second reinforcement sublayers (4a, 4b, 5a, 5b), each first reinforcement sublayer (4a, 5a) being interposed between the shielding layer (6) and the respective second reinforcement sublayer (4b, 5b).

6. Protective case for batteries (1) as claimed in any of claims 1 to 5, wherein the metal material (7) is nickel and/or copper.

7. Protective case for batteries (1) as claimed in any of claims 1 to 6 wherein the case comprises a base (8) and a side wall (9) which extends from the base (8) to an opening (10).

8. A method of forming a protective case (100) for batteries of vehicles as claimed in any of claims 1 to 7, said method comprising the steps of:
- providing (101) a co-extruded or co-molded multilayer structure (3);
- providing (102) a mold for a battery case;
- placing (103) the multilayer structure (3) in the mold;
- injecting (105) resin into the mold to form the protective case (1),
- removing (106) the protective case (1) from the mold after curing of the injected resin.

9. Method of forming a protective case (100) for vehicle batteries as claimed in claim 8 wherein the step of providing (103) the multilayer structure (3) comprises the sub-steps of
- forming (107) a first reinforcement layer (4) and a second reinforcement layer (5);
- forming (108) a shielding layer (6) by depositing metal material (7) on a polyester fabric or on a polyester non-woven fabric;
- assembling (109) the multilayer structure (3) by placing the shielding layer (6) between the first (4) and the second (5) reinforcement layers.

10. Method of forming a protective case (100) for vehicle batteries as claimed in claim 9, wherein the step of assembling (109) the multilayer structure (3) is carried out using a co-extrusion or co-molding process.

11. Method of forming a protective case (1) for vehicle batteries as claimed in any of claims 8 to 10, wherein the step of injecting the resin (105) is carried out by High-Pressure Resin Transfer Molding (HP-RTM).

## Patentansprüche

1. Schutzgehäuse für Batterien (1) von Fahrzeugen, umfassend:
- eine Harzmatrix (2),
- eine Mehrschichtstruktur (3), die in die Harzmatrix (2) eingebettet und konfiguriert ist, um eine Batterie zu schützen, wobei die Mehrschichtstruktur (3) mindestens eine erste Verstärkungsschicht (4) und eine zweite Verstärkungsschicht (5) umfasst,
- eine Abschirmschicht (6), die konfiguriert ist, um die von der Batterie emittierte elektromagnetische Strahlung abzuschirmen, und zwischen der ersten (4) und zweiten (5) Verstärkungsschicht angeordnet ist, wobei die Abschirmschicht (6) eine Dispersion von Metallmaterial (7) aufweist
**dadurch gekennzeichnet, dass** die Abschirmschicht (6) Folgendes umfasst:
- ein Polyestergewebe mit darauf dispergiertem Metallmaterial (7) oder
- einen Vliesstoff aus Polyester mit darauf dispergiertem Metallmaterial (7).

2. Schutzgehäuse für Batterien (1) nach Anspruch 1, wobei die Mehrschichtstruktur (3) coextrudiert oder cogeformt ist.

3. Schutzgehäuse für Batterien (1) nach Anspruch 1 oder 2, wobei die erste Verstärkungsschicht (4) und die zweite Verstärkungsschicht (5) Verstärkungsmaterialfasern umfassen.

4. Schutzgehäuse für Batterien (1) nach Anspruch 3, wobei die Verstärkungsmaterialfasern Glasfasern und/oder Kohlenstofffasern sind.

5. Schutzgehäuse für Batterien (1) nach einem der Ansprüche 1 bis 4, wobei eine jede der ersten Verstärkungsschicht (4) und der zweiten Verstärkungsschicht (5) eine erste und eine zweite Verstärkungsunterschicht (4a, 4b, Sa, Sb) umfasst, wobei jede erste Verstärkungsunterschicht (4a, Sa) zwischen der Abschirmschicht (6) und der jeweiligen zweiten Verstärkungsunterschicht (4b, Sb) angeordnet ist.

6. Schutzgehäuse für Batterien (1) nach einem der Ansprüche 1 bis 5, **dadurch gekennzeichnet, dass** das Metallmaterial (7) Nickel und/oder Kupfer ist.

7. Schutzgehäuse für Batterien (1) nach einem der Ansprüche 1 bis 6, wobei das Gehäuse eine Basis (8) und eine Seitenwand (9) umfasst, die sich von der Basis (8) zu einer Öffnung (10) erstreckt.

8. Verfahren zum Bilden eines Schutzgehäuses (100) für Batterien von Fahrzeugen nach einem der Ansprüche 1 bis 7, wobei das Verfahren die folgenden Schritte umfasst:
- Bereitstellen (101) einer coextrudierten oder cogeformten Mehrschichtstruktur (3);
- Bereitstellen (102) einer Form für ein Batteriegehäuse;
- Platzieren (103) der Mehrschichtstruktur (3) in die Form;
- Einspritzen (105) von Harz in die Form, um das Schutzgehäuse (1) zu bilden,
- Entfernen (106) des Schutzgehäuses (1) aus der Form nach dem Aushärten des eingespritzten Harzes.

9. Verfahren zum Bilden eines Schutzgehäuses (100) für Fahrzeugbatterien nach Anspruch 8, wobei der Schritt zum Bereitstellen (103) der Mehrschichtstruktur (3) die folgenden Teilschritte umfasst:
- Bilden (107) einer ersten Verstärkungsschicht (4) und einer zweiten Verstärkungsschicht (5);
- Bilden (108) einer Abschirmschicht (6) durch Ablagern von Metallmaterial (7) auf einem Polyestergewebe oder auf einem Vliesstoff aus Polyester;
- Zusammenbauen (109) der Mehrschichtstruktur (3) durch Platzieren der Abschirmschicht (6) zwischen der ersten (4) und der zweiten (5) Verstärkungsschicht.

10. Verfahren zum Bilden eines Schutzgehäuses (100) für Fahrzeugbatterien nach Anspruch 9, wobei der Schritt zum Zusammenbauen (109) der Mehrschichtstruktur (3) unter Verwendung eines Co-Extrusions- oder Co-Formverfahrens ausgeführt wird.

11. Verfahren zum Bilden eines Schutzgehäuses (1) für Fahrzeugbatterien nach einem der Ansprüche 8 bis 10, wobei der Schritt zum Einspritzen des Harzes (105) durch Hochdruck-Harztransferformung (HP-RTM) ausgeführt wird.

## Revendications

1. Boîtier de protection pour batteries (1) de véhicules comprenant :
- une matrice de résine (2),
- une structure multicouche (3) intégrée dans la matrice de résine (2) et configurée pour protéger une batterie, la structure multicouche (3) comprenant au moins une première couche de renforcement (4) et une seconde couche de renforcement (5),
- une couche de blindage (6) configurée pour protéger le rayonnement électromagnétique émis par la batterie et disposée entre la première (4) et la seconde (5) couche de renforcement, la couche de blindage (6) ayant une dispersion de matériau métallique (7)
**caractérisé en ce que** la couche de blindage (6) comprend :
- un tissu de polyester dans lequel est dispersé un matériau métallique (7), ou
- un tissu non tissé en polyester dans lequel est dispersé un matériau métallique (7).

2. Boîtier de protection pour batteries (1) selon la revendication 1, dans lequel la structure multicouche (3) est co-extrudée ou co-moulée.

3. Boîtier de protection pour batteries (1) selon la revendication 1 ou 2, dans lequel la première couche de renforcement (4) et la seconde couche de renforcement (5) comprennent des fibres de matériau de renforcement.

4. Boîtier de protection pour batteries (1) selon la revendication 3, dans lequel les fibres du matériau de renforcement sont des fibres de verre et/ou des fibres de carbone.

5. Boîtier de protection pour batteries (1) selon l'une quelconque des revendications 1 à 4, dans lequel chacune de la première couche de renforcement (4) et de la seconde couche de renforcement (5) comprennent des premières et secondes sous-couches de renforcement (4a, 4b, Sa, Sb), chaque première sous-couche de renforcement (4a, Sa) étant interposée entre la couche de blindage (6) et la seconde sous-couche de renforcement respective (4b, Sb).

6. Boîtier de protection pour batteries (1) selon l'une quelconque des revendications 1 à 5, dans lequel le matériau métallique (7) est du nickel et/ou du cuivre.

7. Boîtier de protection pour batteries (1) selon l'une quelconque des revendications 1 à 6, dans lequel le boîtier comprend une base (8) et une paroi latérale (9) qui s'étend de la base (8) à une ouverture (10).

8. Procédé de fabrication d'un boîtier de protection (100) pour batteries de véhicules selon l'une quelconque des revendications 1 à 7, ledit procédé comprenant les étapes suivantes :
- fournir (101) une structure multicouche co-extrudée ou co-moulée (3) ;
- fournir (102) un moule pour un boîtier de batterie ;
- placer (103) la structure multicouche (3) dans le moule ;
- injecter (105) de la résine dans le moule pour former le boîtier de protection (1),
- retirer (106) le boîtier de protection (1) du moule après durcissement de la résine injectée.

9. Procédé de fabrication d'un boîtier de protection (100) pour batteries de véhicules selon la revendication 8, dans lequel l'étape consistant à fournir (103) la structure multicouche (3) comprend les sous-étapes suivantes
- former (107) une première couche de renforcement (4) et une seconde couche de renforcement (5) ;
- former (108) une couche de blindage (6) en déposant un matériau métallique (7) sur un tissu de polyester ou sur un tissu non tissé en polyester ;
- assembler (109) la structure multicouche (3) en plaçant la couche de blindage (6) entre la première (4) et la seconde (5) couche de renforcement.

10. Procédé de fabrication d'un boîtier de protection (100) pour batteries de véhicules selon la revendication 9, dans lequel l'étape d'assemblage (109) de la structure multicouche (3) est réalisée par un procédé de co-extrusion ou de comoulage.

11. Procédé de fabrication d'un boîtier de protection (1) pour batteries de véhicules selon l'une quelconque des revendications 8 à 10, dans lequel l'étape d'injection de la résine (105) est réalisée par moulage par transfert de résine à haute pression (HP-RTM).
